Europäisches Patentamt

European Patent Office

Office européen des brevets

(19)

(11) Publication number: **0 267 602**
**A2**

(12) **EUROPEAN PATENT APPLICATION**

(21) Application number: 87116673.2

(22) Date of filing: 11.11.87

(51) Int. Cl.4: **H01L 21/48** , **H01L 23/52**

(30) Priority: 12.11.86 US 929975

(43) Date of publication of application:
18.05.88 Bulletin 88/20

(84) Designated Contracting States:
DE FR GB

(71) Applicant: **International Business Machines Corporation**
**Old Orchard Road**
**Armonk, N.Y. 10504(US)**

(72) Inventor: **Chance, Dudley Augustus**
**91 Taunton Hill Road**
**Newtown, CT 06470(US)**
Inventor: **Goland, David Brian**
**425 Bedford Road**
**Bedford Hills, N.Y. 10507(US)**

(74) Representative: **Teufel, Fritz, Dipl.-Phys. et al**
**IBM Deutschland GmbH. Europäische**
**Patentdienste Postfach 265**
**D-8000 München 22(DE)**

(54) Method for producing high density multilayered glass-ceramic structures with metallic based conductors.

(57) A method forming high density multilayered glass-ceramic circuits with copper conductors is disclosed herein. In the process a preburnoff process is performed in an atmosphere including nitrogen gas with a very low partial pressure of oxygen, with the glass-ceramic temperature being raised gradually from 25°C to the binder burnout temperature. Burnout of the residual carbon in the binder material is then performed by maintaining that temperature for several hours in the presence of wet nitrogen gas and hydrogen, with a ratio of water vapor to hydrogen gas of $10^4$. The temperature is, then, lowered to at or slightly below said binder burn off temperature for approximately one hour. Subsequently, the temperature is raised to the coalescence and/or crystallization temperature of said ceramic material and held for two hours while remaining in the dry forming gas environment.

FIG. 1

# METHOD FOR PRODUCING HIGH DENSITY MULTILAYERED GLASS-CERAMIC STRUCTURES WITH METAL-LIC BASED CONDUCTORS

## Background of the Invention

### Field of the Invention

This invention relates to methods for producing multilayered glass-ceramic structures with metallic-based conductors therein. More particularly, this invention relates to a method of producing high density packages of said glass-ceramic and metal based conductors.

### Description of Related Art

As known in the art of semiconductor packaging devices, multilayered glass-ceramic circuits are comprised of electrically insulating laminated layers of glass-ceramic with patterned conductors deposited on said layers. As known and practiced in the art, the multilayered glass-ceramic circuits are produced in a sequence of process steps.

Typically, the stacked glass-ceramic layers with conductors thereon are heated to temperatures so that the binder material incorporated with the glass-ceramic is burned off. Upon removal of said binder material, the laminated stack is further fired at a higher temperature so as to cause the glass to coalesce and densify and the conductor metal particles to become a sintered dense metallic.

However, one of the troublesome problems in fabricating these multilayer glass-ceramic/Cu substrates is developing a sintering cycle that results in dense (Ö98%) glass-ceramic. Dense glass-ceramic is required for strong substrates and adherent surface metal pads for pin brazing and wire bonding. In addition, fine line patterns on ceramic surfaces require dense, pore-free surfaces for the reduction of defects to acceptable levels.

In U.S. Patent 4,504,339, "Method for Producing Multilayered Glass-Ceramic Structure with Copper-Based Conductors Therein" a process for firing glass-ceramic green sheets with a binder of polymethyl methacrylate, a plasticizer of dibutyl phthalate, and solvents of methlethylketone, methyl alcohol, and butyl alcohol is described. The firing temperature for depolymerizing and elimination of the binder is 550 to 650°C. Heating above that range is taught to be avoided as it causes the glass components to coalesce, thereby hindering the removal of the binder. The sintering process used includes heat treatment in an atmosphere of nitrogen and water such that at temperatures for binder elimination water dissociates resulting in a partial pressure from $10^{-7}$ to $10^{-8}$ of hydrogen in the atmosphere. In the next step, the vapor pressure of the atmosphere was changed to dry nitrogen and the temperature was raised to 900°C for one hour during which time the glass-ceramic and metal conductor densifies. The glass-ceramic may have less than satisfactory strength depending on the quantity of porosity and residual carbon.

This is different than the subject invention as the subject invention uses a hydrogen and nitrogen mixture during densification in different steps of the sintering process. In addition, the subject invention includes a drying step for several hours at a temperature range of 700-800°C which is not taught by Kamehara. By these added steps, it is surmised that gas bubble formation are suppressed in the substrate material effectively yielding a denser glass-ceramic.

In U. S. Patent 4,234,367 of Herron et al, the glass-ceramic is first heated gradually for about 5 hours up to a temperature of 800°C in an atmosphere of pure nitrogen gas at least initially which is changed to water vapor and hydrogen gas later. Heating is then held at a steady temperature of about 800°C for about six hours in an atmosphere with a ratio of water vapor to hydrogen gas of $10^4$. The atmosphere is then changed to pure nitrogen gas and the heat is raised about 100° for a couple of hours and then the temperature is dropped over several hours. As stated above, the process of the subject invention does not use water vapor in the initial heating step, but uses the hydrogen and nitrogen gases instead. At col. 3, lines 26-34 of the patent, it is pointed out that there was difficulty in using neutral or reducing atmospheres with wet and dry forming gas at temperatures below the coalescence temperature of the glass-ceramic. Unexpectedly, this process does use dry forming gas below that temperature and the problem of drastic volume changes caused by formation of copper oxide has been overcome. Moreover, the third step of drying for a few hours at or below 800°C is also not taught by Herron et al.

It is therefore an object of the present invention to provide a process for yielding dense (greater 98% glass-ceramic with minimal porosity) multilayer glass-ceramic circuits with metal based conductors.

It is still a further object of the present invention that said process insures that the oxidation of residual carbon does not take place during glass densification, hence, higher residual carbon greater than 100 ppm can be tolerated.

Another object of the present invention is that the oxidation of carbon during the firing cycle is such that CO and $CO_2$ pressure does not exceed one atmosphere during glass densification.

## SUMMARY OF THE INVENTION

A method of forming high density multilayered glass-ceramic circuits with copper conductors is disclosed herein.

In the process a burnoff process is performed in an atmosphere including nitrogen gas with a very low partial pressure of oxygen, with the glass-ceramic temperature being raised gradually from 25°C to about 700-800°C.

Burnoff of the residual carbon in the binder material is then performed by maintaining the temperature at from about 700 to 800°C for several hours in the presence of wet nitrogen gas and hydrogen, with a ratio of water vapor to hydrogen gas of $10^4$.

Then, the temperature is held at about 700 to 800°C (preferably 700 to 785°C) for several hours in the presence of dry forming gas (hydrogen/nitrogen in a ratio of 1/10) to remove water from the ceramic material.

Subsequently, the temperature is raised to about 920 to about 960°C for densification of said ceramic material and crystallization of said ceramic material for two hours while remaining in the dry forming gas environment. This dry forming gas environment prevents oxidation of the remaining carbon and avoids the evolution of carbon dioxide or carbon monoxide which would produce bubbles in the ceramic material, leading to porosity.

In the pre-burnoff process the binder is treated in an atmosphere of forming gas (hydrogen and nitrogen gases) by raising the glass-ceramic temperature from 25°C to about 700-800°C, (preferably 785°C) at a rate of about 3°/min. Burnoff of the residual carbon in the binder material is performed by maintaining the temperature at from about 700 to 800°C (preferably 770 to 785°C) for several hours in the presence of wet nitrogen gas and forming gas (10% hydrogen, 90% nitrogen) with a ratio of water vapor to hydrogen gas of $10^4$.

## BRIEF DESCRIPTION OF THE DRAWINGS

FIG. 1 is a graph illustrating the different stages and temperature cycle of the present invention.

FIG. 2 is a graph illustrating the equivalent partial pressure of $O_2$ for various $H_2O/H_2$ ratios versus temperature.

FIG. 3 is a graph illustrating the areas of stability of the condensed phases of Cu and Cu oxides at various partial pressures of $O_2$ versus temperature.

FIG. 4 is a graph illustrating the equilibrium partial pressures of CO and $CO_2$ in the presence of carbon at various oxygen partial pressures at 1100°K.

## DETAILED DESCRIPTION OF THE INVENTION

In accordance with the subject invention, a method of forming high density multilayered glass-ceramic circuits is taught herein. In this process a sintering step which is compatible with copper (Cu) internal metallurgy and various surface metallurgies such as nickel (Ni) alloys is described. In addition, the disclosed ambient and temperature cycle is designed to diminish the oxidation of residual carbon thereby densifying the glass structure. It is hypothesized that the residual carbon left after burnoff causes carbon monoxide and carbon dioxide gases to form bubbles in the coalescing glass and reduce the glass density.

In the method according to the subject invention, it should be readily understood by those skilled in the art that a multilayered structure of green sheet glass-ceramic layers with conductors deposited thereon has been formed by those techniques known in the art. One preferred process for the fabrication of such green sheet substrates is that process of U. S. Patent No. 4,234,367, specifically Steps 1-7, Columns 6-7.

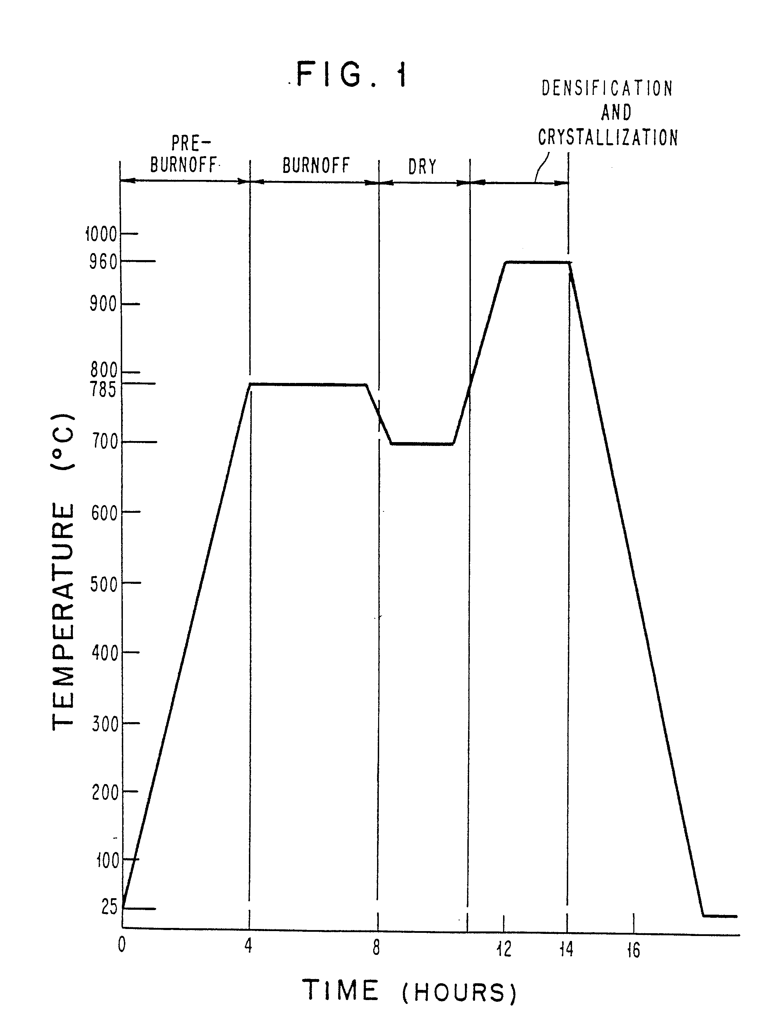

For the subject invention, the composite processing sequence is shown in FIG. 1. From the FIGURE, the green sheet is initially heated in a pre-burnoff process in an atmosphere including nitrogen gas with a very low partial pressure of oxygen. The glass-ceramic temperature is raised gradually from 25°C to about 700-800°C (preferably 785°C) at a rate of about 3°C/min. Burnoff of the residual carbon in the binder material is then accomplished by maintaining the temperature within the temperature range (of 700°C to 785°C) for several hours in the presence of wet nitrogen gas and forming gas (10% hydrogen and 90% nitrogen) with a ratio of water vapor to hydrogen gas of $10^4$.

After about 4-48 hours at 700°C to 785°C, the wet nitrogen/forming gas ambient is switched to a dry forming gas ($H_2/N_2$ in a ratio of 1/10) and the temperature is maintained in a range of about at 700°C-800°C for several hours.

At this point, the heat is elevated at rate of 2-10°C/min. to the densification and crystallization temperature of the glass (approximately 920°C to 980°C for about 2 hours while remaining in the dry forming gas environment. This dry forming gas prevents the oxidation of the remaining carbon and avoids the evolution of carbon dioxide or carbon monoxide which would produce bubbles in the ceramic material, leading to porosity. The temperature is then reduced to ambient at a rate of about 5-10°C/min.

To better appreciate and understand the invention, the thermodynamics and kinetics of above described reactions are presented herein.

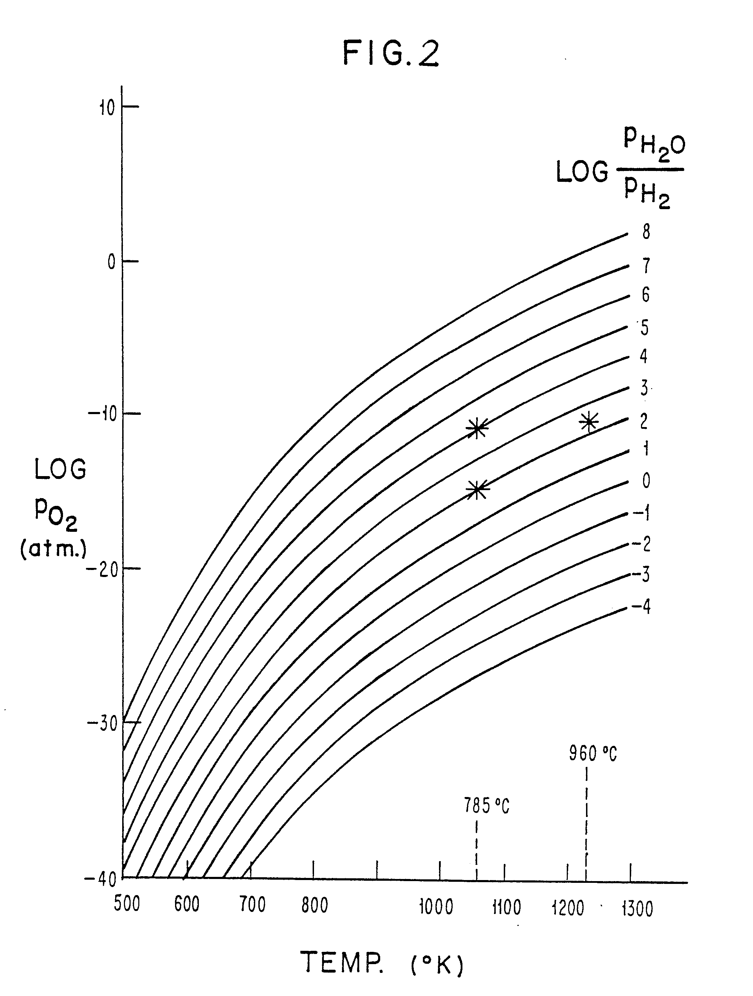

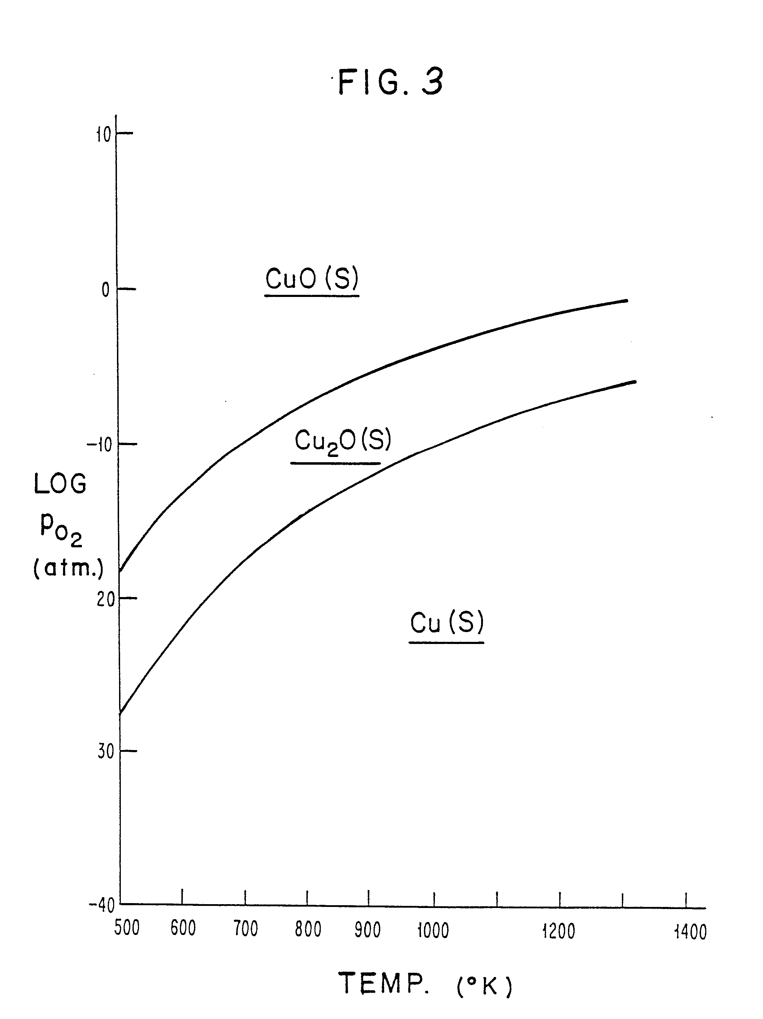

FIG. 2 is a thermochemical diagram showing equivalent partial pressures of $O_2$ for various $H_2O/H_2$ ratios and temperatures. FIG. 3 shows the stability of the condensed phases of Cu and Cu oxides at various partial pressures of $O_2$ and temperatures. These two curves may be superimposed and the $H_2O/H_2$ ratios at which Cu is oxidized to $Cu_2O$ may be determined for various temperatures. For example, at 785°C (1058°K) one may use an ambient consisting of $H_2O/H_2$ ratio equal to $10^4$ without oxidizing Cu. This is, in fact, the ambient used to burn off carbon and is composed by mixing $N_2$ (at a dew point of 82°C) and forming gas (10% $H_2$ in $N_2$). Clearly other ambients with $H_2O/H_2$ ratios less than $10^{4.7}$ can be used. The temperature of 785°C was chosen as the temperature at which densification of the glass particles become significant if held for several hours but this temperature may vary with glass-ceramic composition.

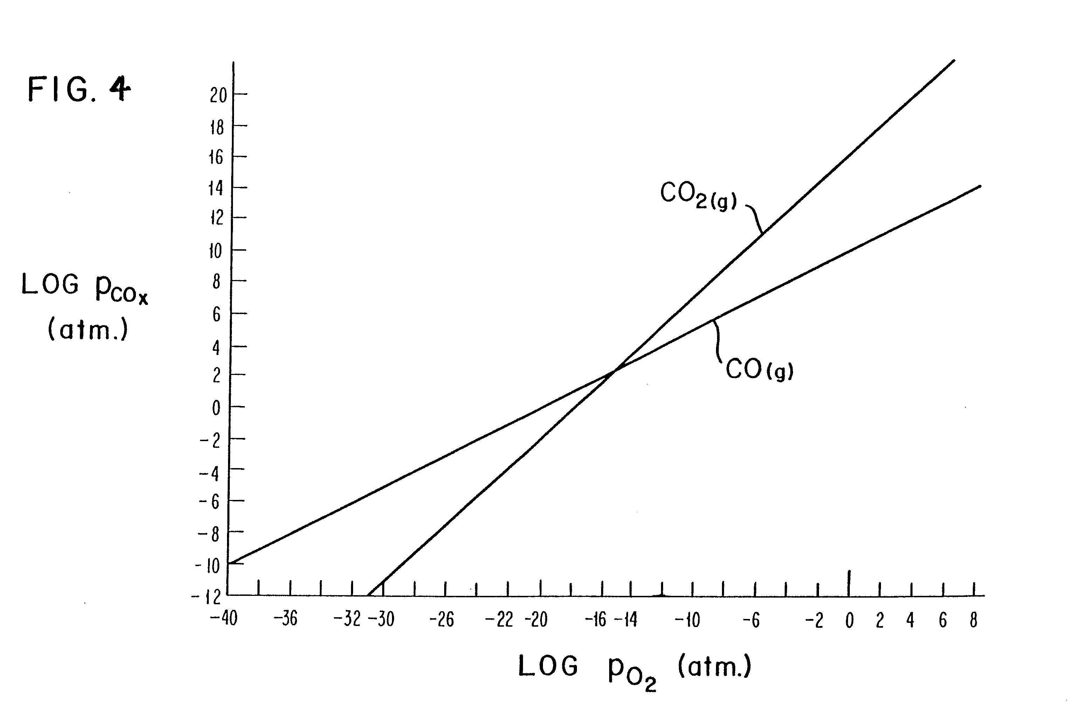

Subsequent to the removal of most carbon by oxidation it is then necessary to densify in an ambient such that further oxidation of residual carbon will not occur. The thermochemical diagram for the oxidation of carbon is shown in FIG. 4. At 1100°K (823°C) and at a partial pressure of oxygen $10^{-10}$ atmosphere (i.e. the equivalent partial pressure of oxygen when $H_2O/H_2 \sim 10^4$) we find that the equilibrium partial pressure of $CO_2$ is $\sim 10^7$ atmosphere. This implies that carbon particles buried in glass and exposed to oxygen having chemical potential equivalent to a partial pressure of $10^{-10}$ atmosphere will oxidize until the pressure of $CO_2$ builds to $10^7$ atmosphere. Such reaction and the bubbles that form is apparently the major cause of low density in glass-ceramic.

We can suppress the oxidation of carbon by insuring that residual carbon is exposed to an oxygen partial pressure less than $10^{-20}$ atmosphere. At this point the equilibrium partial pressure of CO is less than one atmosphere (i.e. the minimum pressure required to generate a bubble in a system at atmospheric pressure). From FIG. 2 at T = 1100°K, Log $P_{O_2}$ = -20, $H_2O/H_2$ is less than $10^{-1}$.

In the sintering cycle disclosed the conditions stated above are insured by 1) removing $H_2O$ from the system, and 2) increasing the $H_2$ content in the ambient. The removal of $H_2O$ from the system and hence ambient is done by a drying cycle where the temperature is reduced to 700°C and dry forming gas ($H_2/N_2$ = 0.1) flowed through the system. The latter temperature is chosen to reduce densification of the glass during drying.

After sufficient drying, densification and crystallization can then proceed by increasing the temperature to 920 - 960°C in the same ambient without further oxidation of carbon. The time required for removal of $H_2O$ from the furnace depends on each furnace design especially the presence of porous materials and metal surfaces which can be oxidized and reduced.

## Claims

1. A method of forming high density multilayered glass-ceramic structures with copper based metallurgy wherein at least one green sheet of said glass-ceramic is comprised of a thermoplastic organic binder having dispersed therein particles of a crystallizable glass or glass and ceramic mixtures having a coalescence and crystallization temperature below the melting point of copper and there is formed on a surface of a first said green sheet a pattern of a nonrefractory copper based conductor forming composition wherein the predominant component of said conductor is copper such that superimposing a second sheet on said surface of said first sheet sandwiches said pattern therebetween and said sheets are laminated together, comprising the steps of

a) preheating said laminate in an atmosphere of nitrogen gas with a partial pressure of hydrogen gas with the temperature being gradually raised to a burnout temperature between the anneal and softening points of the glass used,

b) substituting an atmosphere of wet nitrogen gas and forming gas for said atmosphere of step (a) and maintaining said laminate at said burnout temperature for several hours,

c) subsequently lowering the heating temperature at or slight below said burnout temperature to a drying temperature with substituting an ambient of dry forming gas of hydrogen and nitrogen for the atmosphere of step (b) and maintaining said laminate at said drying temperature for approximately one hour, and, subsequently

d) heating said laminate to the coalescence and/or crystallization temperature of said glass and maintaining said laminate at said temperature for approximately two hours.

2. A method according to Claim 1 wherein said burnout temperature is in the range of 700°C to 785°C.

3. A method according to Claim 2 wherein said laminate is preheated from 25°C to said burnout temperature at a rate of 3°C per minute.

5. A method according to Claim 3 wherein the ratio of hydrogen to nitrogen gas is $10^{-1}$ during said preheating step.

5. A method according to Claim 2 wherein the ratio of water vapor to hydrogen is $10^4$ during the burnoff step.

6. A method according to Claim 2 wherein said drying temperature is in the range of 700°C to 800°C.

7. A method according to Claim 6 wherein the ratio of dry hydrogen gas to nitrogen gas is greater than 1 to 10.

8. A method according to Claim 6 wherein said densification and crystallization temperature is in the range of 920° to 980°C.

9. A method according to Claim 6 wherein said densification and crystallization temperature is in the range of 900° to 960°C.

# FIG. 1

DENSIFICATION
AND
CRYSTALLIZATION

PRE-
BURNOFF    BURNOFF    DRY

TEMPERATURE (°C)

1000
960
900
800
785
700
600
500
400
300
200
100
25

0    4    8    12    14    16

TIME (HOURS)

# FIG.2

# FIG. 3

CuO (S)

Cu$_2$O (S)

Cu (S)

LOG P$_{O_2}$ (atm.)

TEMP. (°K)

FIG. 4